# EUROPEAN PATENT APPLICATION

(11) **EP 4 601 003 A1**
(43) Date of publication of application: **13.08.2025**
(21) Application number: 25156342.5
(22) Date of filing: 06.02.2025
(51) Int. Cl.: H01L 23/495, H05K 1/02, H05K 1/18

(54) **SEMICONDUCTOR PACKAGE DESIGN WITH TERMINALS FOR CONNECTING TO EXTERNAL CAPACITOR**

(30) Priority: 07.02.2024 US 202463550927 P
(71) Applicant: Tesla, Inc., Austin, TX 78725 (US)
(72) Inventor: CHI, William Thomas, Austin, Texas, 78725 (US); SINGH, Ashkay, Austin, Texas, 78725 (US); THUTA, Satish, Austin, Texas, 78725 (US)
(74) Representative: Liesegang, Eva

(57) **Abstract**

The present disclosure is directed to a packaged semiconductor component and circuit assembly that includes such a packaged semiconductor component and a capacitor. The packaged semiconductor component includes a semiconductor die that includes a field effect transistor, a side source terminal positioned on a first side of packaged semiconductor component and connected to a source of the field effect transistor, and a drain terminal positioned on a second side of packaged semiconductor component and connected to a drain of the field effect transistor, wherein the first side is adjacent to the second side. The capacitor is electrically connected between the source terminal and the drain terminal.

## Description

### CROSS-REFERENCE TO RELATED APPLICATION

This application claims the benefit of U.S. Provisional Patent Application No. 63/550,927, entitled "SEMICONDUCTOR PACKAGE DESIGN WITH CONTACTS FOR CONNECTING TO EXTERNAL CAPACITOR," filed on February 7, 2024, the disclosure of which is hereby incorporated by reference in its entirety and for all purposes.

### BACKGROUND

### Technical Field

This disclosure relates to semiconductor packages. In particular, embodiments of this disclosure relate to semiconductor packages with contacts to achieve low parasitic inductance for connections with an external capacitor and related methods of manufacture.

### Description of Related Technology

Semiconductor devices are used in a wide variety of applications. In some applications, semiconductor devices can incorporate multiple electrical components that are electrically connected with each other. Such electrical connections can result in undesired parasitic inductances. There may be technical problems associated with the parasitic inductances, such as distorting electrical signals between the components.

### SUMMARY

The innovations described in the claims each have several aspects, no single one of which is solely responsible for its desirable attributes. Without limiting the scope of the claims, some prominent features of this disclosure will now be briefly described.

One aspect of the present disclosure is a circuit assembly, including a packaged semiconductor component and a capacitor. The packaged semiconductor component includes a semiconductor die that includes a field effect transistor, a side source terminal positioned on a first side of packaged semiconductor component and connected to a source of the field effect transistor, and a drain terminal positioned on a second side of packaged semiconductor component and connected to a drain of the field effect transistor. The capacitor is electrically connected between the source terminal and the drain terminal. The first side is adjacent to the second side. The capacitor is external to the packaged semiconductor components, the capacitor electrically connected between the source terminal and the drain terminal.

In one embodiment, the circuit assembly further includes a printed circuit board. The packaged semiconductor component and the capacitor are positioned on the printed circuit board, and the packaged semiconductor component further includes a heat spreader opposite the printed circuit board. In addition, the side source terminal provides mechanical support point for the heat spreader.

In one embodiment, the packaged semiconductor component further includes a plurality of additional drain terminals on the second side and connected to the drain of the field effect transistor and a plurality of source terminals on a third side of the packaged semiconductor component and connected to the source of the field effect transistor, wherein the third side is opposite the second side.

In one embodiment, the packaged semiconductor component further includes a second side source terminal on a side opposite the first side

In one embodiment, each of the first side and the second side of the packaged semiconductor component includes a lead frame.

In one embodiment, the circuit assembly further includes a second packaged semiconductor component and a second capacitor electrically connected between a side source terminal and a drain terminal of the second packaged semiconductor component. The second packaged semiconductor component is rotated 180 degrees relative to the packaged semiconductor component.

In one embodiment, the circuit assembly further includes a printed circuit board. The printed circuit board includes traces, and the capacitor is connected to a trace of the traces.

Another aspect of the present disclosure is a packaged semiconductor component. The packaged semiconductor component includes a semiconductor die, including a field effect transistor having a source, a gate, and a drain, a plurality of drain terminals on a first side of the packaged semiconductor component and connected to the drain, a side source terminal on a second side of the packaged semiconductor component and connected to the source, and a plurality of source terminals on a third side of the packaged semiconductor component and connected to the side source terminal within the packaged semiconductor component. The third side is opposite to the first side, and the second side is adjacent to both the first side and the third side. In addition, the side source terminal is located closer to the first side than the third side.

In one embodiment, the packaged semiconductor component further includes a surface arranged to couple to a printed circuit board and a heat spreader opposite the surface. In addition, the side source terminal provides mechanical support for the heat spreader. Furthermore, the heat spreader has a notch around the side source terminal. Furthermore, the heat spreader has a notch around the side source terminal.

In one embodiment, each of the first side and the second side of the packaged semiconductor component includes a lead frame. In addition, the lead frame includes a stamped flat end.

In one embodiment, the gate is positioned on the third side of the packaged semiconductor component.

In one embodiment, the packaged semiconductor component further includes a gate terminal positioned on the third side of the packaged semiconductor component.

Another aspect of the present disclosure is a circuit assembly, including a packaged semiconductor component. The packaged semiconductor component includes a semiconductor die, including a field effect transistor having a source, a gate, and a drain; a drain terminal connected to the drain; and a source terminal connected to the source, where the drain terminal and the source terminal are on a same side of the packaged semiconductor component. The circuit assembly further includes a capacitor external to the packaged semiconductor component, and the capacitor is electrically connected between the source terminal and the drain terminal.

In one embodiment, the circuit assembly further includes a second capacitor external to the packaged semiconductor component, and the packaged semiconductor component includes a second source terminal on the same side of the packaged semiconductor component as the drain terminal and the source terminal. In addition, the second capacitor is electrically connected between the second source terminal and the drain.

In one embodiment, the circuit assembly further includes a printed circuit board, and the packaged semiconductor component and the capacitor are positioned on the printed circuit board. In addition, the packaged semiconductor component further includes a heat spreader opposite the printed circuit board.

In one embodiment, the packaged semiconductor component includes a gate terminal and a Kelvin source terminal on a side opposite the same side on which the drain terminal and the source terminal are located.

In one embodiment, the packaged semiconductor component includes a plurality of additional source terminals on a side opposite the same side on which the drain terminal and the source terminal are located.
In one embodiment, the packaged semiconductor component includes at least one additional drain terminal on the same side as the drain terminal and the source terminal, and the at least one additional drain terminal is electrically connected to the capacitor external to the packaged semiconductor component.

Another aspect of the present disclosure is a circuit assembly, including a packaged semiconductor component. The packaged semiconductor component includes a semiconductor die comprising a field effect transistor having a source, a gate, and a drain; a plurality of drain terminals on a first side of the packaged semiconductor component and connected to the drain; a side source terminal on a second side of the packaged semiconductor component and connected to the source; and a plurality of source terminals on a third side of the packaged semiconductor component and connected to the side source terminal within the packaged semiconductor component. The first side is opposite the second side, and the third side is orthogonal to the first side and the second side. The circuit assembly further includes a printed circuit board, where the packaged semiconductor component is positioned on the printed circuit board and a capacitor on the printed circuit board. The capacitor is electrically connected between a drain terminal of the plurality of drain terminals and the side source terminal.

In one embodiment, the packaged semiconductor component further includes a heat spreader opposite the printed circuit board. In addition, the heat spreader has a notch around the side source terminal. Furthermore, the side source terminal provides mechanical support for the heat spreader.

In one embodiment, each of the first side and the second side of the packaged semiconductor component includes a lead frame, and the lead frame further includes a stamped flat end.

For purposes of summarizing the disclosure, certain aspects, advantages, and novel features of the innovations have been described herein. It is to be understood that not necessarily all such advantages may be achieved in accordance with any particular embodiment. Thus, the innovations may be embodied or carried out in a manner that achieves or optimizes one advantage or group of advantages as taught herein without necessarily achieving other advantages as may be taught or suggested herein.

### BRIEF DESCRIPTION OF THE DRAWINGS

These and other features, aspects, and advantages of the disclosure are described with reference to the drawings of certain embodiments. It is to be understood that the accompanying drawings, which are incorporated in and constitute a part of this specification, are for the purpose of illustrating concepts disclosed herein and make not be to scale.
FIG. 1A illustrates an example of a circuit assembly according to some embodiments.
FIG. 1B illustrates an example of schematic circuit diagram of the circuit assembly and an external capacitor of FIG. 1A.
FIG. 1C illustrates another example of a circuit assembly according to some embodiments.
FIG. 2A illustrates an example of top side view of a semiconductor component according to embodiments of the disclosure.
FIG. 2B illustrates an example of bottom side view of the semiconductor component of FIG. 2A.
FIG. 3A illustrates an example of an exploded view of a packaged semiconductor component according to embodiments of the disclosure.
FIG. 3B illustrates an example of an array assembly of the packaged semiconductor components according to embodiments of the disclosure.
FIG. 4 illustrates an example of a cross section view of a semiconductor component according to embodiments of the disclosure.
FIG. 5 illustrates an example of a circuit assembly system with two semiconductor packages according to embodiments of the disclosure.
FIG. 6 illustrates an example of a circuit assembly system by implementing a capacitor on top of the circuit assembly system according to embodiments of the disclosure.

### DETAILED DESCRIPTION OF CERTAIN EMBODIMENTS

The following detailed description of certain embodiments presents various descriptions of specific embodiments. However, the innovations described herein can be embodied in a multitude of different ways, for example, as defined and covered by the claims. In this description, reference is made to the drawings where like reference numerals and/or terms can indicate identical or functionally similar elements. It will be understood that elements illustrated in the figures are not necessarily drawn to scale. Moreover, it will be understood that certain embodiments can include more elements than illustrated in a drawing and/or a subset of the elements illustrated in a drawing. Further, some embodiments can incorporate any suitable combination of features from two or more drawings. The headings provided herein are for convenience only and do not necessarily affect the scope or meaning of the claims.

### Introduction

Electronic components containing one or more integrated circuit (IC) dies can be deployed in a wide variety of applications and in a wide variety of environmental conditions. For example, such components can form part of a power electronics system. In some cases, power electronics systems can be used to provide power for an electric vehicle. In some applications, power electronics systems can be part of a stationary energy storage system, such as a system for storing solar energy, a system for delivering power to a destination, and so forth. These are merely examples, and there are many other applications for such systems. In some cases, components can comprise diode switches, field effect transistors (FETs) such as metal-oxide-semiconductor FETS (MOSFETs) (e.g., silicon MOSFETs, GaN MOSFETs, etc.), insulated-gate bipolar transistors (IGBTs), other bipolar transistors, the like, or any suitable combination thereof. Such switches can be included in inverters. In certain applications, switches in packaged semiconductor components disclosed herein can switch voltage in a range from 1 Volt (V) to 150 V, such as in a range from 12 V to 150 V.

A snubber capacitor can be utilized in certain switching components to reduce and/or eliminate voltage transients and/or ringing associated with switching. It can be desirable to reduce and/or minimize parasitic inductance associated with a snubber capacitor connected between the terminals of the switching device. Embodiments of this disclosure can provide low parasitic inductance associated with a snubber capacitor connected between terminals of a switching device and related packaged components for connecting with a snubber capacitor.

Power electronics systems can produce significant amounts of heat. Such heat can present significant problems. For example, excess heat can lead to reduced performance, reduced reliability, reduced lifespan, and so forth. For example, excessive thermal stresses can weaken solder joints, damage semiconductor components, or both. In some applications, surge loads can result in rapid temperature rises. High surge loads can be encountered in various applications such as, for example, when starting portable compressors, HVAC systems, refrigeration systems, electric motors, power converters, or the like. In certain semiconductor package designs, a cooling solution can be implemented in the semiconductor package to dissipate the heat. In some cases, the semiconductor package can be designed to dissipate the heat through a printed circuit board (PCB). For example, top-sided cooling may be used to cool ICs, for example, as described in U.S. Patent No. 10,658,276, entitled "Device with top-side base plate," the disclosure of which is hereby incorporated by reference in its entirety and for all purposes.

Certain semiconductor packaging (e.g., a semiconductor component package) can include die connection terminals (e.g., contact terminals), such as source, drain, and gate of a field effect transistor semiconductor component. The source and drain terminals can be implemented on opposite ends of body of a semiconductor component. For example, switching terminals of the semiconductor component can be arranged with source and drain implemented opposite one another. Some semiconductor components can include an exposed heat spreader facing downward to a surface of a carrier, such as a PCB. In top side cooled devices with an exposed heat spreader at a drain potential, terminals on sides of the device adjacent to a side with source terminals and a side with drain terminals may not make electrical contact with a PCB. The source and drain terminals can be electrically contacted with other components via traces embedded and/or etched on a printed circuit board (PCB). For example, these terminals can be electrically connected with a power generating component that provides a high frequency switching input power signals (e.g., signals utilized for digital to analog converters and/or analog to digital converters) via the PCB traces. However, these traces can generate parasitic effects, such as the parasitic inductances. Such parasitic inductances can lead to signal distortion of high-speed switching signals, impedance mismatches, signal noises, the like, or any combination thereof.

The shape and height of conductive elements of the semiconductor package can also have a detrimental parasitic inductance at certain switching frequencies. Accordingly, there is a need for die packaging that can facilitate operation with relatively low parasitic effects, such as the parasitic inductance. Such semiconductor chip packaging can be designed with internal elements that are low in profile and close to a PCB when mounted.

### Package Design

Aspects of this disclosure relate to semiconductor chip packages (e.g., semiconductor package) with lead frames and electrical component(s) that can reduce and/or minimize parasitic effects. Particularly, the semiconductor chip packages can include various traces to electrically connect between integrated components of the semiconductor chip packages. Such traces can generate unwanted parasitic inductances, and the electrical component(s) can be integrated in the semiconductor chip packages to mitigate these unwanted parasitic inductances. In addition, each semiconductor component can include lead frames and implement the electrical component(s). Such lead frames can be formed with a desired shape and can provide heating solutions for the semiconductor package. In some cases, the lead frames also provide electrical connections between terminals of the semiconductor components. For example, the lead frame can provide an electrical connection to a die backside as well as top surfaces of a semiconductor die. The lead frames can also be a shape formable (e.g., pre-formed lead frames) and can be implemented as pre-positioned or arranged conductors in desirable shapes during the assembly process.

In some cases, the electrical components can be implemented to reduce and/or minimize parasitic effects. For instance, the capacitor and connections to the semiconductor package can be arranged so as to achieve low parasitic inductance. When a high speed switching signal is applied to an input of the semiconductor component, parasitic inductances can be generated between traces of carrier, such as the PCB. To reduce and/or minimize the parasitic inductance, a capacitor, such as a snubber capacitor, can be implemented between traces.

In embodiments disclosed herein, a capacitor together with source and drain terminals can be implemented to reduce and/or minimize the parasitic inductance. The source and drain terminals of the semiconductor package can be connected via the capacitor. The placement of the source and drain leads of the semiconductor package can allow for compact connections between the capacitor and the source and drain leads. This capacitor connected between source and drain of a switching device can generally referred to as a "snubber capacitor" in this disclosure. During the operation of the semiconductor components, such as high-speed switching, the source and drain leads can be connected by a snubber capacitor component via PCB traces. A tight current path and/or "triangular" loop area can be formed by source-capacitor-drain affect ringing or voltage overshoot in the semiconductor switch waveform. In experiments where a snubber capacitor was implemented onto a semiconductor package to bridge directly between drain and source, the parasitic inductance was reduced. In some embodiments, two source lead frames can be extended on both sides of the semiconductor component by providing a snubber capacitor positioned on either side for PCB layout.

In embodiments disclosed herein, heat transfer can be focused on a top side of a semiconductor package. Top side cooling can be desirable in certain applications, for example, due to bottom-side mounting surface temperature, PCB layout and/or feature considerations. The technology disclosed herein can be applied to dual-side cooled semiconductor packages. Certain designs can have conductor elements exposed on the top and bottom and can have design features to hold position during assembly and mold encapsulation. This can control molding flash and resin bleed. Accordingly, a need for grinding can be reduced or eliminated.

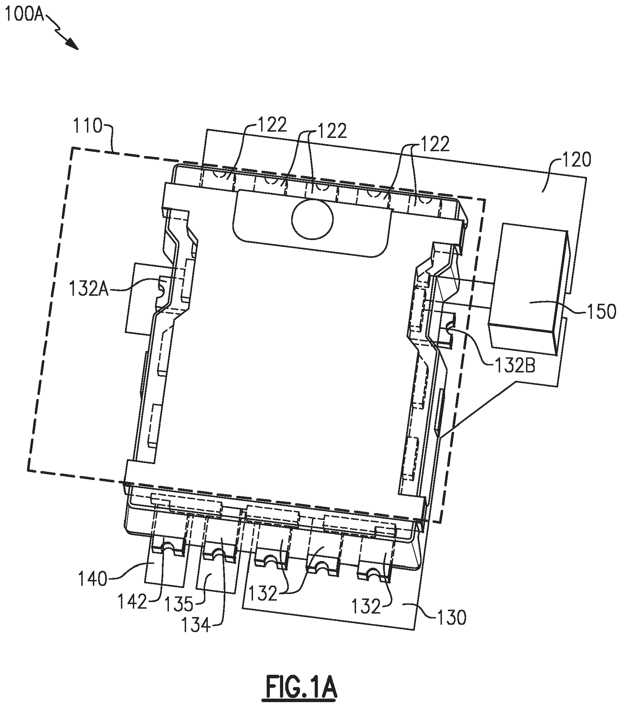

FIG. 1A illustrates a circuit assembly 100A according to embodiments of this disclosure. For the purpose of illustration, the circuit assembly 100A is illustrated with a package of a single packaged semiconductor component 110. However, the circuit assembly 100A can include a plurality of packaged semiconductor components 110, and the present disclosure does not limit the number of packaged semiconductor components 110. As illustrated in FIG. 1A, the circuit assembly 100A can include a packaged semiconductor component 110, traces 120, 130, 140, and a capacitor 150. The packaged semiconductor component 110 can be implemented on a carrier, such as a PCB (not shown in FIG. 1A). The packaged semiconductor component 110 can be electrically connected with other components, such as other power supply components, other semiconductor components, etc., via the PCB. For example, the traces 120, 130, 140 can be etched onto the PCB and configured to provide the electrical contact areas or lines between the packaged semiconductor component 110 and other components. The traces 120, 130, 140 can each have any suitable shape and/or area for a particular application.

The trace 120 can provide electrical contact to the designated terminals (e.g., the drain terminals 122 of the packaged semiconductor component 110). The trace 130 can provide electrical contact to another group of designated terminals (e.g., the source terminals 132 of the packaged semiconductor component 110). The trace 140 can provide electrical contact to a designated terminal (e.g., the gate terminal 142 of the packaged semiconductor component 110). In some cases, the trace 135 can be combined with the trace 130 and provide as contact area of the source of the packaged semiconductor component 110. Alternatively, the terminal 134 and trace 135 can be arranged as a Kelvin source. These configurations are provided as examples, and the configurations can be modified based on specific applications.

As further illustrated in FIG. 1A, the capacitor 150 can have ends connected to respective traces. For example, the trace 120 and trace 130 can be capacitively coupled via the capacitor 150. Such a capacitor 150 can be referred to as a snubber capacitor. The capacitor 150 can be utilized to mitigate an unwanted signal generated by a parasitic effect (e.g., parasitic inductance caused by inductive coupling of traces 120 and 130), such as the voltage spikes, that can be occurred in high-speed switching operation of the circuit assembly. For example, the parasitic inductance caused by the two nearby traces, such as between the trace 120 and the trace 130 can cause the parasitic inductance. In embodiments of this disclosure, these parasitic effects caused by the inductive couplings between traces can be mitigated by the capacitor 150. For instance, the capacitor 150 can absorb the energy associated with the voltage spikes. In some cases, the capacitor 150 can be soldered onto the traces 120 and 130. The capacitance value of the capacitor 150 can be determined based on the applied input signals (e.g., one or more of applied voltage, frequency, or waveform) and the distance between the traces. The capacitor 150 can be any suitable capacitor for the specification of the circuit assembly 100A.

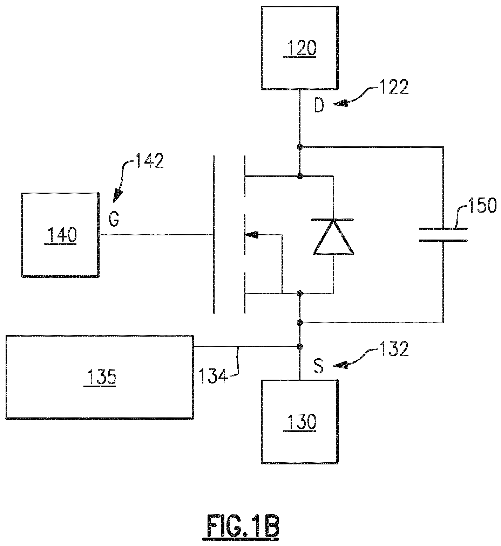

FIG. 1B illustrates a schematic circuit diagram of the circuit assembly 100A and capacitor 150 of FIG. 1A. The drain terminal(s) 122, the source terminal(s) 132 (including 132A, 132B), the gate terminal 142, and the Kelvin source 134 of the packaged semiconductor component 110 can correspond to points 122, 132, 142, and 134, respectively, of the schematic view in FIG. 1B. In addition, the traces 120, 130, 140, and 135 in FIG. 1A are illustrated with the same numerical representations in FIG. 1B. As illustrated in FIG. 1B, the capacitor 150 can be connected between the drain terminal(s) 122 and source terminal(s) 132 of the packaged semiconductor component 110. As further illustrated in FIG. 1A, the packaged semiconductor component 110 can also provide the source terminals 132A, 132B on both sides of the packaged semiconductor component 110.

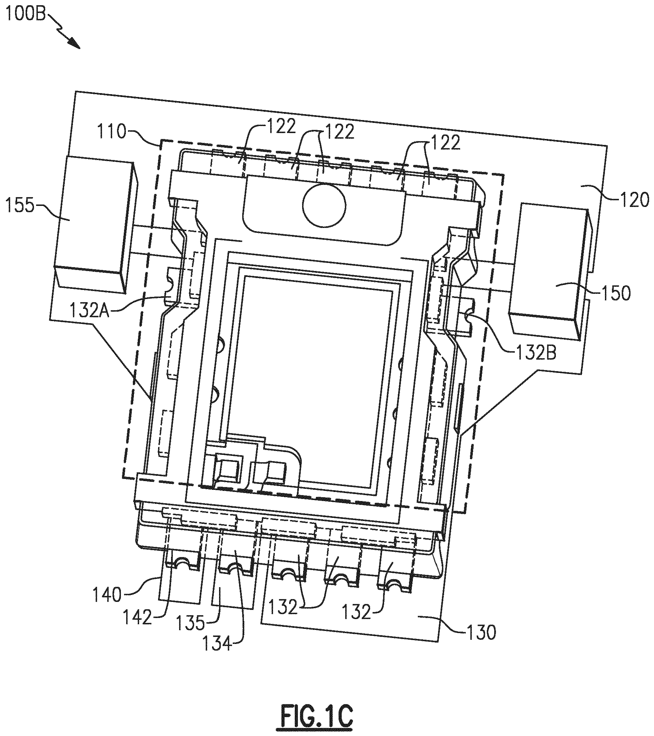

FIG. 1C illustrates a circuit assembly 100B according to embodiments of this disclosure. As shown in FIG. 1C, the circuity assembly 100B includes an additional capacitor 155 relative to the circuit assembly 100A illustrated in FIG. 1A. The traces 120 and 130 of the circuit assembly 100B are also shaped and configured to connect the additional capacitor 155 between the source terminals 132 and the drain terminals 122 of the packaged semiconductor component 110. Similar components of circuit assembly 100B can function similarly or the same as like components of the circuit assembly 100A of FIG. 1A. For the purpose of illustration, the circuit assembly 100B is illustrated with a package of a single packaged semiconductor component 110. However, the circuit assembly 100B can include a plurality of packaged semiconductor components 110, and the present disclosure does not limit the number of packaged semiconductor components 110.

As illustrated in FIG. 1C, each of the capacitor 150 and the additional capacitor 155 can have ends connected to respective traces. For example, the trace 120 and trace 130 can be capacitively coupled via the capacitor 150 and the additional capacitor 155 on opposing sides of the packaged semiconductor component 110. Each of the capacitor 150 and the additional capacitor 155 can mitigate an unwanted signal generated by a parasitic effect (e.g., parasitic inductance caused by inductive coupling of traces 120 and 130), such as voltage spikes, which can occur in high-speed switching operation of the circuit assembly 100B. For example, the parasitic inductance caused by the two nearby traces, such as between the trace 120 and the trace 130 can cause the parasitic inductance. In embodiments of this disclosure, these parasitic effects caused by the inductive coupling between traces can be mitigated by the capacitor 150 and the additional capacitor 155. For instance, each of the capacitor 150 and the additional capacitor 155 can absorb the energy associated with the voltage spikes. In some cases, each of the capacitor 150 and the additional capacitor 155 can be soldered onto the traces 120 and 130. Having two capacitors 150 and 155 in parallel with each other can be advantageous for mitigating parasitic effects in certain applications. The capacitance value of each of the capacitor 150 and the additional capacitor 155 can be determined based on the applied input signals (e.g., one or more of applied voltage, frequency, or waveform) and distance between the traces. Each of the capacitor 150 and the additional capacitor 155 can be any suitable capacitor for the specification of the circuit assembly 100B.

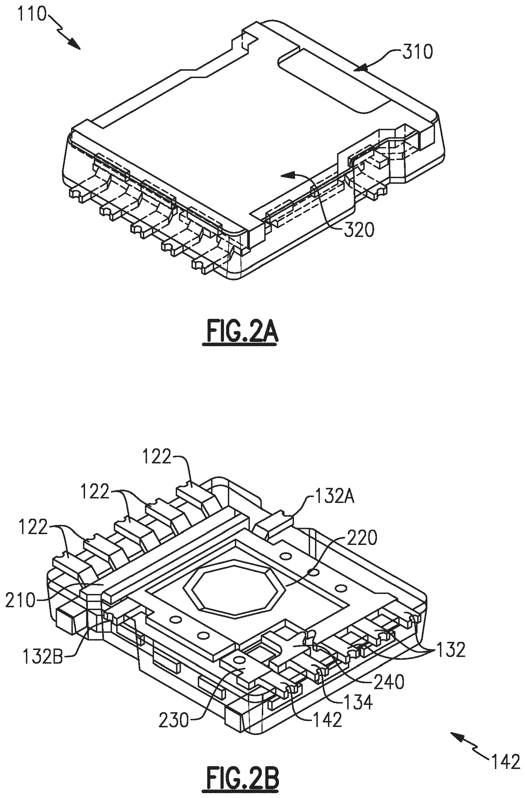

FIG. 2A illustrates a top side view of the packaged semiconductor component 110 of FIG. 1A according to an embodiment. The packaged semiconductor component 110 can include a package structure 310 that can enclose the packaged semiconductor component 110. The package structure 310 can be made of a rigid mold resin. The package structure 310 can be disposed on top of a die paddle 320. The die paddle 320 can be referred to as a "clip." The die paddle 320 can function as a heat spreader in any suitable embodiments disclosed herein. In some cases, the heat spreader can be the top side heat spreader with a relatively large area. The die paddle 320 can be used to provide electrical connections to a top surface of the packaged semiconductor component 110 and can function as a heat spreader. In some examples, a semiconductor package assembly or manufacturing orientation may favor that the die paddle 320 be assembled lastly atop the die in which this may be referenced as a "clip." The package structure can also include molding material. The packaged semiconductor component 110 can include a bottom side that includes stamped leads. The stamped leads can be flat.

FIG. 2B illustrates a bottom view of the packaged semiconductor component 110 of FIG. 1A according to an embodiment. The packaged semiconductor component 110 can include drain terminal(s) 122, source terminal(s) 132 (including 132A, 132B), gate terminal 142, and Kelvin source terminal 134. The packaged semiconductor component 110 can be assembled on top of a PCB, where the top of the PCB provides various traces, such as traces 120, 130, 140, and/or 135, as described in FIG. 1A. In some embodiments, each of the drain terminal(s) 122, the source terminal(s) 132 (including 132A, 132B), the gate terminal 142, and the Kelvin source terminal 134 can be electrically connected to one of the traces by assembling the packaged semiconductor component 110 on top of the PCB. For example, each of the drain terminal(s) 122, the source terminal(s) 132 (including 132A, 132B), the gate terminal 142, and the Kelvin source terminal 134 by contacting its corresponding traces can provide contacts for monitoring the packaged semiconductor component 110 (e.g., contacts for temperature sensor such as a thermocouple), and so forth. In some embodiments, the drain terminal(s) 122, the source terminal(s) 132 (including 132A, 132B), the gate terminal 142, and the Kelvin source terminal 134 by contacting its corresponding traces can extend beyond the bulk of the packaged semiconductor component 110. In some embodiments, the drain terminal(s) 122, the source terminal(s) 132 (including 132A, 132B), the gate terminal 142, and the Kelvin source terminal 134 by contacting its corresponding traces can be flush with an outer surface of the packaged semiconductor component 110. In some embodiments, the drain terminal(s) 122, the source terminal(s) 132 (including 132A, 132B), the gate terminal 142, and the Kelvin source terminal 134 by contacting its corresponding traces can be recessed in one or more directions from an outer surface of the packaged semiconductor component 110. The Kelvin source terminal 134 can be provided as a terminal that provides decoupling the current paths (e.g., control current path and load current path). In some embodiments, the Kelvin source terminal 134 can be combined (e.g., formed a signal piece) with the source 132.

The packaged semiconductor component 110 can include side source terminals 132A and 132B. These side source terminals 132A and 132B can be electrically connected with a common trace with the source terminals 132 within the packaged semiconductor component 110. For example, the trace 130 can be shaped to cover the area of the side source terminals 132A and 132B and the source terminals 132. As illustrated side source terminals 132A and 132B are positioned on sides of the packaged semiconductor component 110, where other source terminals 132 and drain terminals 122 are positioned on other respective sides of the packaged semiconductor component 110. Molding material and the die paddle 320 can have respective notches around the side source terminals 132A and 132B. These notches may serve to recess terminals to make the side source terminals 132A and 132B less obtrusive for handling or close spacing among other components within a PCB layout. The shape and position of these notches can provide electrical surface creepage distances sufficient to mitigate and/or prevent arcing to adjacent terminals of different voltage or function. The side source terminals 132A and 132B are each located on a side of packaged semiconductor component 110 that is adjacent to other source terminals 132 and also adjacent to drain terminals 122. The side source terminals 132A and 132B are located closer to the closest drain terminal 122 than to the closest other source terminal 132. The side source terminals 132A and 132B can also provide a mechanical structure of the packaged semiconductor component 110. For example, when the packaged semiconductor component 110 is assembled, these side source terminals 132A and 132B can provide mechanical support during and/or after the manufacturing processes of the packaged semiconductor component 110, including the die paddle 320.

In some embodiments, the packaged semiconductor component 110 can include frames 352, 310, 230, and 240. These frames can be conductive frames, such as lead frames of the packaged semiconductor component 110. These frames can be implemented with a pattern that can provide electrical contact with terminals of a die, such as drain, source, and gate (not shown in FIG. 2B). For example, the drain frame 352, source frame 310, gate frame 230, and Kelvin source frame 240 can be arranged based on the drain, source, gate, and Kelvin source of the terminals of the die, respectively. Thus, the source terminal(s) 132 (including 132A, 132B), the drain terminal(s) 122, the gate terminal 142, and the Kelvin source 134 of the packaged semiconductor component 110 can be electrically connected with the drain frame 352, source frame 310, gate frame 230, and Kelvin source frame 240, respectively.

While reference is made to source contacts, drain contacts, and gate contacts in the present disclosure, this is for illustrative purposes only. In general, stamped leads can be used to provide source terminals, gate terminals, drain terminals, Kelvin source terminals, control terminals, input terminals, output terminals, sensor terminals, base terminals, emitter terminals, collector terminals, ground terminals, reference terminals, shorting terminals, or any other suitable electrical terminal.

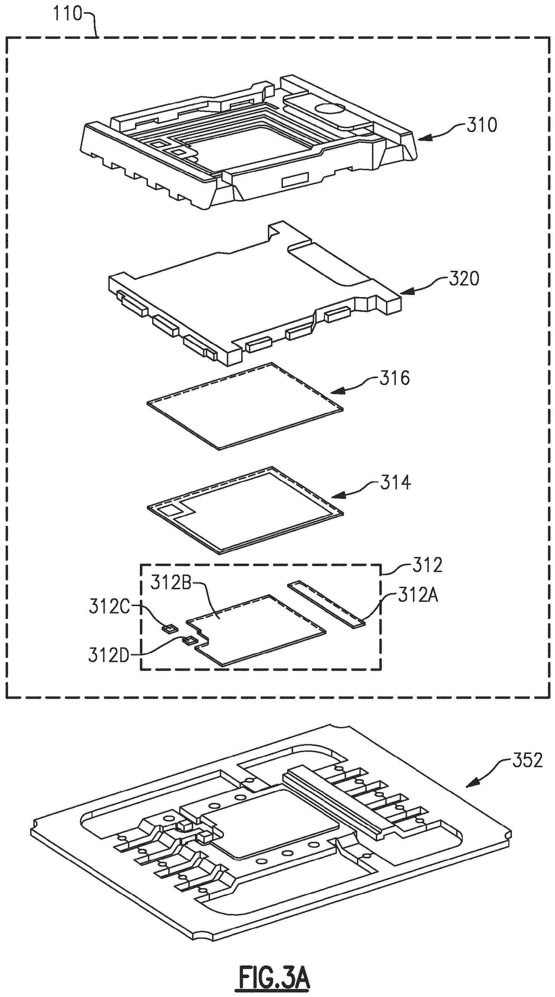

FIGs. 3A-3B illustrate example embodiments of semiconductor component and assembly in an array structure.

FIG. 3A illustrates an exploded view of the packaged semiconductor component 110 according to some embodiments. Each packaged semiconductor component 110 can be mounted on a frame 352 and assembled with other semiconductor components. In some embodiments, the frame 352 can provide mechanical support and the electrical contact in the assembly.

As shown in FIG. 3A, the packaged semiconductor component 110 can include a layer of bonding material 312, a die 314, a layer of die attach material 316, and a packaging structure 310, and a die paddle 320 (e.g., die clip). In some examples, the layer of bonding material 312 can be formed based on a pattern that can include multiple areas to provide electrical bonding with corresponding die connection terminals (e.g., contact terminals), such as source (including Kelvin source), drain, and gate of a semiconductor component. For example, the die attach pads 312A, 312B, 312C, and 312D can provide electrical connections to the drain terminal, the source terminal, the gate terminal, and the Kelvin source terminal of the die connection terminals, respectively. In some examples, the layer of die attach material 312 can be formed by a conductive material, such as solder, conductive epoxy, and the like.

Further referring to FIG. 3A, in some examples, field effect transistors (FETs) such as metal-oxide-semiconductor field effect transistors (MOSFETs) (e.g., GaN MOSFETs) can be implemented on the die 314. Thus, the die 314 can include terminals, such as the drain, source (and kelvin source), and gate. In some cases, the layer of die attach material 316 can be assembled (e.g., bonded) on the top of the die 314. In some examples, the layer of die attach material 316 may cover the top surface of the die 314. In addition, the layer of die attach material 316 can be configured to bond the die 314 with the packaging structure 310. The layers of bonding material 314 and the layer of die attach material 316 can be formed with a same type of bonding material (e.g., conductive bonding material). In some cases, the structure of the packaged semiconductor component 110 can be modified such that the die paddle 320 can be atop the layer of die attach material 316. In some assembly processes, the die paddle 320 can be assembled after assembling the die 314 and the layer of die attach material 316. In these assembly processes, the die paddle 320 can be referred to as "a clip."

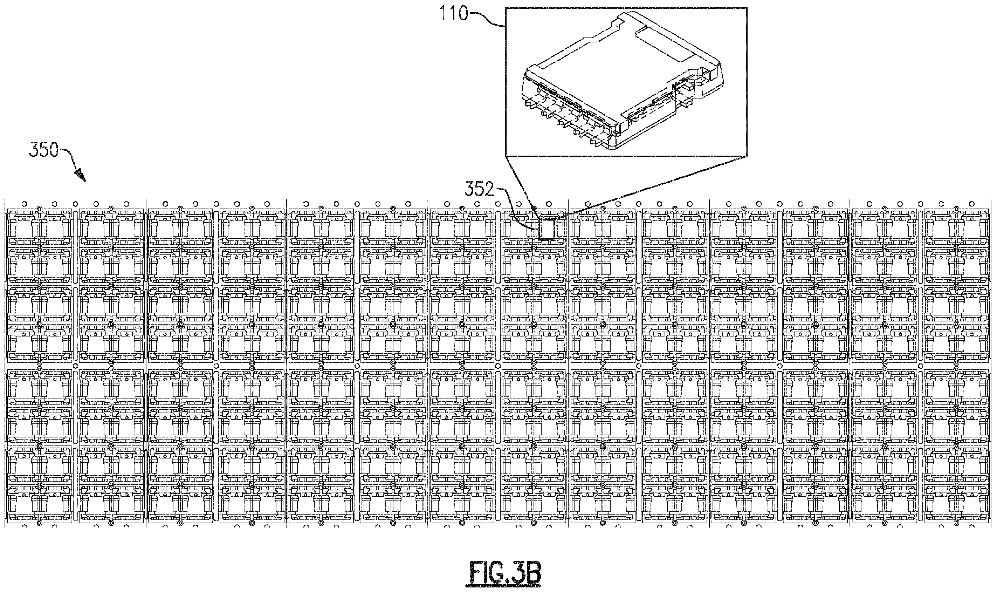

FIG. 3B illustrates an example of an array assembly 350 of the packaged semiconductor components 110. As illustrated in FIG. 3B, the die paddle or clip 320 can be mounted on each device lead frame unit 352 of the array assembly 350. In some embodiments, packaged semiconductor components 110 can be assembled or mounted with different orientations. During the assembly process of the array assembly 350, the device lead frame unit 352 can alternatively be mounted on top on each die paddle or clip 320.

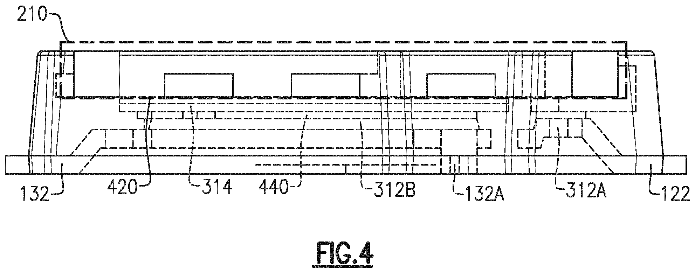

FIG. 4 illustrates a cross section of the packaged semiconductor component 110 of FIG. 1A. As shown in FIG. 4, the packaged semiconductor component 110 can include a die paddle or clip 320, a die attach structure 420, a die 314, a lead attach structure 440, a drain lead frame 312A, a source lead frame 312B, a side source terminal 132A (side source terminal 132B is not shown), and a source terminal 132 (other side source terminals 132, Kelvin source terminal 134, and gate terminal 142 are not shown in FIG. 4). The die paddle 320 can function as a heat spreader. The die paddle 320 can also be used to provide electrical connections to the top surface of the packaged semiconductor component 110. The die attach structure 420 can be used to attach the die 314 and the die paddle 320. The die 314 can be implemented with field effect transistors (FETs) such as metal-oxide-semiconductor field effect transistors (MOSFETs) (e.g., Si MOSFETs or GaN MOSFETs), thus, the die 314 can include terminals, such as the drain, source, and gate. The lead attach structure 440 can attach the die 314 with the lead frames 312A and 312B (lead frames 312C and 312D are not shown in FIG. 4).

In some embodiments, the lead frame 312A can be connected with the drain terminals 122, and the lead frame 312B can be connected with the source terminals 132 and side source terminals 132A and 132B (side source terminal 132 is not shown in FIG. 4). These lead frames 312A and 312B by connecting with corresponding terminals 122, 132, and 132A, the drain, source, and gate terminals of the die can be connected with other semiconductor components or any electrical components. For example, the drain terminal of the die 314 can be connected to the lead frame 312A and the drain terminal 122. Then, the drain terminals 122 can be electrically coupled with trace 120, as described with reference to FIGs. 1A and 1B. Likewise, the source terminal of the die 314 can be connected to the lead frame 312B and the source terminals 132. Then, the source terminals 132 can be electrically coupled with trace 130, as described with reference to FIGs. 1A and 1B. Likewise, the gate terminal of the die 314 can also be connected to a trace 140 via the lead frame 312D (shown in FIG. 3), gate terminal 135 (shown in FIG. 1A), and trace 140 (shown in FIG. 1A).

The side source terminals 132A and 132B shown in FIGs. 1A and 2 are implemented in providing proximity to the drain terminals 122. For example, since the drain terminals 122 and side source terminal 132A are in proximity distance with each other, the traces 120 and 130 also can be implemented in proximity distance with each traces, as shown in FIG. 1A. Thus, an electronic component 150, such as a capacitor, can be implemented between the traces 120 and 130, in accordance with embodiments disclosed herein.

In some embodiments, the drain terminals 122 and the source terminals 132 can provide mechanical support points when mounting the packaged semiconductor component 110 on a carrier, such as a PCB, or to support lead frames 312A and 312B at a desired position within a lead frame array during assembly. In some embodiments, the side terminals 132A and 132B can provide additional mechanical support points.

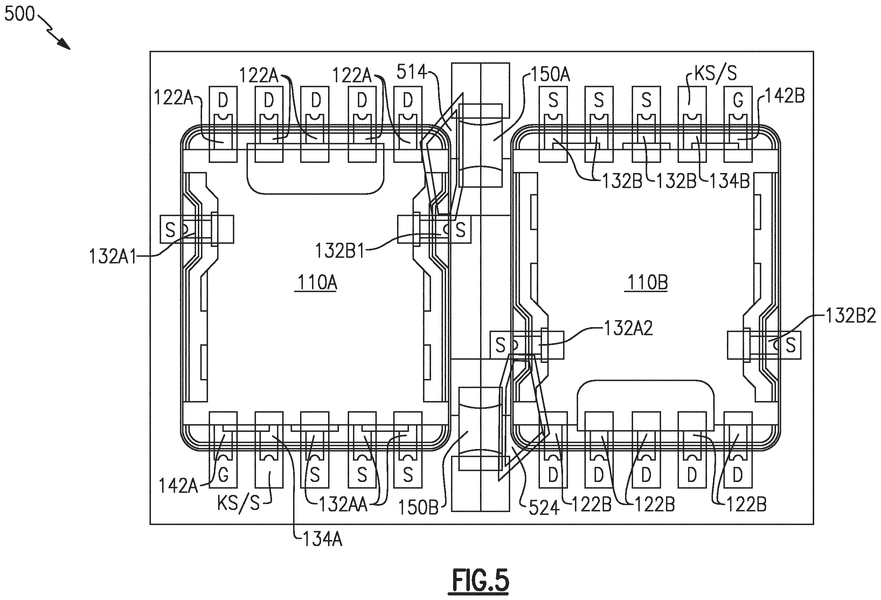

FIG. 5 depicts a circuit assembly 500 that incorporates two packaged semiconductor components 110A and 110B. Each of these components can be packaged in a manner akin to that of semiconductor package 110, as shown in FIGs. 1A and 2B, respectively. In FIG. 5, it is demonstrated that the semiconductor components 110A and 110B are assembled with each rotated by 180 degrees relative to the other. For instance, the semiconductor component 110A is oriented in the opposite direction, having been rotated 180 degrees relative to the semiconductor component 110B. For example, the drain terminals 122A of the semiconductor component 110A are positioned on the upper side (e.g., upper side of FIG. 5) and the source terminals 132AA, the Kelvin source terminal 134A, and the gate terminal 142A are positioned on the lower side (e.g., lower side of FIG. 5). The semiconductor component 110A can be assembled in the opposite direction relative to the semiconductor component 110A. For example, the drain terminals 122B of the semiconductor component 110B are positioned on the lower side (e.g., lower side of FIG. 5) and the source terminals 132BB, the Kelvin source terminal 134B, and the gate terminal 142B are positioned on the upper side (e.g., upper side of FIG. 5). As further shown in FIG. 5, the side source terminals 132A1 and 132B1 of the semiconductor component 110A can be located on an upper side with respect to the side source terminals 132A2 and 132B2 of the semiconductor component 110B. Thus, the capacitors 150A and 150B can be implemented while minimizing the form factor of the circuit assembly 500.

A capacitor 150A is connected to the packaged semiconductor component 110A via traces (not depicted in FIG. 5) that link to the component's drain and source terminals. Similarly, a capacitor 150B is connected to semiconductor component 110B through traces (also not shown in FIG. 5) attached to its drain and source terminals. The integration of capacitors 150A and 150B creates capacitor loops 514 and 524, respectively. In certain designs, it is possible to implement more than two semiconductor components. For example, an array comprising multiple semiconductor components can be created by arranging each component to be rotated 180 degrees relative to the adjacent one.

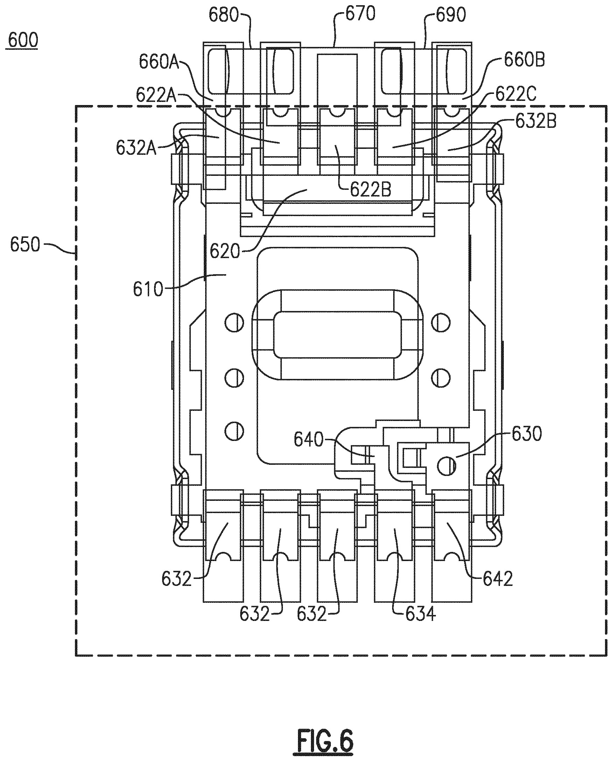

FIG. 6 illustrates a circuit assembly system 600 by implementing a capacitor on top of the circuit assembly system 600 according to embodiments of this disclosure. The circuit assembly system 600 includes a packaged semiconductor component 650 and capacitors 680 and 690 on a PCB. The packaged semiconductor component 650 includes source terminals and drain terminals on a common side. Accordingly, a snubber capacitor 680 can be electrically connected between a source terminal 632A and a drain terminal 622A by a trace with low parasitic inductance. Similarly, a snubber capacitor 690 can be electrically connected between a source terminal 632B and a drain terminal 622C by a trace with low parasitic inductance. The location of the terminals on the packaged semiconductor component 650 enables a snubber capacitor to be connected between source and drain in a compact layout with low parasitic inductance.

For the purpose of the illustration, FIG. 6 illustrates a bottom view of the packaged semiconductor component 650 and two capacitors 680 and 690 without showing a PCB and showing a portion of traces on the PCB. The packaged semiconductor component 650 and the capacitors 680, 690 can be implemented on a PCB, for example, similar to as described in one or more of the above embodiments. The capacitors 680 and/or 690 can be electrically connected between source and drain in any suitable way. As shown in FIG. 6, the PCB may include traces 660A, 660B, and 670 (e.g., only a portion of the traces of the |PCB are shown in FIG. 6) that are illustrated as being connected with the source terminal 632A, the source terminal 632B, and the drain terminal(s) 622A-C, respectively. The gate terminal 642, the other source terminal 632, and the Kelvin source terminal 634 can be connected to traces of the PCB that are not shown in FIG. 6. In some embodiments, the source terminal 632A and the drain terminal(s) 622A-622C can be coupled by implementing a capacitor 680 between the trace 660A and trace 670. In some cases, the source terminal 632B and the drain terminal(s) 622A-622C can be coupled by implementing a capacitor 690 between the trace 660A and trace 670. In some embodiments, the traces 660A and 660B can be formed within the same trace.

The layout of the source frame 610, the drain frame 620, the gate frame 630, and the Kelvin source frame 640 can be arranged as shown in FIG. 6. In some implementations, the layout can be determined based on the layout of the terminals of the die (e.g., the drain, source (and Kelvin source), and gate). For example, as illustrated in FIG. 6, the source frame 610 can be patterned to cover the source terminal(s) of the die, such that the source terminals of the die are electrically connected to terminals on opposite sides of the packaged semiconductor component 650. In the packaged semiconductor component 650, the source terminal(s) of the die are electrically connected to source terminals 632A and 632B and source terminals 632. Furthermore, the drain frame 620 can be patterned to cover the drain terminal(s) of the die. The drain frame 620 can electrically connect the drain terminal(s) of the die to drain terminals 622A-622C, as illustrated in FIG. 6. In addition, the gate frame 630 and the Kelvin source frame 640 can electrically connect terminal(s) of the die to gate terminal 642 and Kelvin source terminal 634, respectively.

In some embodiments, the circuit assembly system 600 may include two capacitors 680 and 690. These capacitors 680, 690 can be implemented between the source terminal(s) and drain terminal(s) via the source trace 660A and 660B (for the purpose of illustration, only a portion of the source trace is shown in FIG. 6) and the drain trace 670. For example, as shown in FIG. 6, the source terminal 632A is electrically connected to the source trace 660A, and the other source terminal 632B is electrically connected to the source trace 660B. In addition, the drain terminals 622A-622C can be connected to the drain trace 670. Thus, the capacitor 680 can be electrically connected between the source terminal 632A and the drain terminals 622A-622C by a short trace. Furthermore, the capacitor 690 can be electrically connected between the source terminal 632B and the drain terminals 622A-622C by a short trace. The traces shown in FIG. 6 can represent a portion of the traces. In some embodiments, one of the capacitors 680 or 690 can be implemented in the circuit assembly system 600. In other embodiments, both the capacitors 680 and 690 can be implemented in the circuit assembly system 600.

### Additional Embodiments

In the foregoing specification, the disclosure has been described with reference to specific embodiments. It will, however, be evident that various modifications and changes may be made thereto without departing from the broader spirit and scope of the disclosure. The specification and drawings are, accordingly, to be regarded in an illustrative rather than restrictive sense.

Indeed, although this disclosure is in the context of certain embodiments and examples, it will be understood by those skilled in the art that the inventions extend beyond the specifically disclosed embodiments to other alternative embodiments and/or uses of the inventions and equivalents thereof. In addition, while several variations of the embodiments have been shown and described in detail, other modifications, which are within the scope of this disclosure, will be readily apparent to those of skill in the art based upon this disclosure. It is also contemplated that various combinations or sub-combinations of the specific features and aspects of the embodiments may be made and still fall within the scope of the disclosure. It should be understood that various features and aspects of the disclosed embodiments can be combined with, or substituted for, one another in order to form varying modes of the embodiments disclosed herein. Any methods disclosed herein need not be performed in the order recited. Thus, it is intended that the scope of the disclosure should not be limited by the particular embodiments described above.

It will be appreciated that the systems and methods of the disclosure each have several innovative aspects, no single one of which is solely responsible or required for the desirable attributes disclosed herein. The various features and processes described above may be used independently of one another or may be combined in various ways. All possible combinations and subcombinations are intended to fall within the scope of this disclosure.

Certain features that are described in this specification in the context of separate embodiments also may be implemented in combination in a single embodiment. Conversely, various features that are described in the context of a single embodiment also may be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination. No single feature or group of features is necessary or indispensable to each and every embodiment.

It will also be appreciated that conditional language used herein, such as, among others, "can," "could," "might," "may," "e.g.," and the like, unless specifically stated otherwise, or otherwise understood within the context as used, is generally intended to convey that certain embodiments include, while other embodiments do not include, certain features, elements and/or steps. Thus, such conditional language is not generally intended to imply that features, elements, and/or steps are in any way required for one or more embodiments or that one or more embodiments necessarily include logic for deciding, with or without author input or prompting, whether these features, elements and/or steps are included or are to be performed in any particular embodiment. The terms "comprising," "including," "having," and the like are synonymous and are used inclusively, in an open- ended fashion, and do not exclude additional elements, features, acts, operations, and so forth. In addition, the term "or" is used in its inclusive sense (and not in its exclusive sense) so that when used, for example, to connect a list of elements, the term "or" means one, some, or all of the elements in the list. In addition, the articles "a," "an," and "the" as used in this application and the appended claims are to be construed to mean "one or more" or "at least one" unless specified otherwise. Similarly, while operations may be depicted in the drawings in a particular order, it is to be recognized that such operations need not be performed in the particular order shown or in sequential order, or that all illustrated operations be performed, to achieve desirable results. Further, the drawings may schematically depict one or more example processes in the form of a flowchart. However, other operations that are not depicted may be incorporated in the example methods and processes that are schematically illustrated. For example, one or more additional operations may be performed before, after, simultaneously, or between any of the illustrated operations. Additionally, the operations may be rearranged or reordered in other embodiments. In certain circumstances, multitasking and parallel processing may be advantageous. Moreover, the separation of various system components in the embodiments described above should not be understood as requiring such separation in all embodiments, and it should be understood that the described program components and systems may generally be integrated together in a single software product or packaged into multiple software products. Additionally, other embodiments are within the scope of the following claims. In some cases, the actions recited in the claims may be performed in a different order and still achieve desirable results.

Further, while the methods and devices described herein may be susceptible to various modifications and alternative forms, specific examples thereof have been shown in the drawings and are herein described in detail. It should be understood, however, that the disclosure is not to be limited to the particular forms or methods disclosed, but, to the contrary, the disclosure is to cover all modifications, equivalents, and alternatives falling within the spirit and scope of the various implementations described and the appended claims. Further, the disclosure herein of any particular feature, aspect, method, property, characteristic, quality, attribute, element, or the like in connection with an implementation or embodiment can be used in all other implementations or embodiments set forth herein. Any methods disclosed herein need not be performed in the order recited. The methods disclosed herein may include certain actions taken by a practitioner; however, the methods can also include any third-party instruction of those actions, either expressly or by implication. The ranges disclosed herein also encompass any and all overlap, sub-ranges, and combinations thereof. Language such as "up to," "at least," "greater than," "less than," "between," and the like includes the number recited. Numbers preceded by a term such as "about" or "approximately" include the recited numbers and should be interpreted based on the circumstances (e.g., as accurate as reasonably possible under the circumstances, for example ±5%, ±10%, ±15%, etc.). Phrases preceded by a term such as "substantially" include the recited phrase and should be interpreted based on the circumstances (e.g., as much as reasonably possible under the circumstances). For example, "substantially constant" includes "constant." Unless stated otherwise, all measurements are at standard conditions including temperature and pressure.

As used herein, a phrase referring to "at least one of' a list of items refers to any combination of those items, including single members. As an example, "at least one of: A, B, or C" is intended to cover: A, B, C, A and B, A and C, B and C, and A, B, and C. Conjunctive language such as the phrase "at least one of X, Y and Z," unless specifically stated otherwise, is otherwise understood with the context as used in general to convey that an item, term, etc. may be at least one of X, Y or Z. Thus, such conjunctive language is not generally intended to imply that certain embodiments require at least one of X, at least one of Y, and at least one of Z to each be present. The headings provided herein, if any, are for convenience only and do not necessarily affect the scope or meaning of the devices and methods disclosed herein.

Accordingly, the claims are not intended to be limited to the embodiments shown herein but are to be accorded the widest scope consistent with this disclosure, the principles and the novel features disclosed herein.

## Claims

1. A circuit assembly comprising:
a packaged semiconductor component comprising a semiconductor die that includes a field effect transistor, a side source terminal positioned on a first side of the packaged semiconductor component and connected to a source of the field effect transistor, and a drain terminal positioned on a second side of the packaged semiconductor component and connected to a drain of the field effect transistor, wherein the first side is adjacent to the second side; and
a capacitor external to the packaged semiconductor component, the capacitor electrically connected between the side source terminal and the drain terminal.

2. The circuit assembly of Claim 1, further comprising a printed circuit board, the packaged semiconductor component and the capacitor positioned on the printed circuit board, and the packaged semiconductor component further including a heat spreader opposite the printed circuit board.

3. The circuit assembly of Claim 2, wherein the side source terminal provides a mechanical support point for the heat spreader.

4. The circuit assembly of one of the preceding claims, wherein the packaged semiconductor component further comprises:
a plurality of additional drain terminals on the second side and connected to the drain of the field effect transistor; and
a plurality of source terminals on a third side of the packaged semiconductor component and connected to the source of the field effect transistor, wherein the third side is opposite the second side.

5. The circuit assembly of one of the preceding claims, the packaged semiconductor component further comprises a second side source terminal on a side opposite the first side.

6. The circuit assembly of one of the preceding claims, wherein each of the first side and the second side of the packaged semiconductor component comprises a lead frame.

7. The circuit assembly of one of the preceding claims, further comprising a second packaged semiconductor component and a second capacitor electrically connected between a side source terminal and a drain terminal of the second packaged semiconductor component, the second packaged semiconductor component being rotated 180 degrees relative to the packaged semiconductor component.

8. The circuit assembly of one of the preceding claims, further comprising a printed circuit board, wherein the printed circuit board comprises traces, and wherein the capacitor is connected to a trace of the traces.

9. The circuit assembly of one of the preceding claims further comprising:
a plurality of drain terminals on the second side of the packaged semiconductor component and connected to the drain;
a plurality of source terminals on a third side of the packaged semiconductor component and connected to the side source terminal within the packaged semiconductor component, wherein the third side is opposite to the second side, wherein the first side is adjacent to both the second side and the third side, wherein the side source terminal is located closer to the second side than the third side.

10. The packaged semiconductor component of Claim 9, further comprising:
a surface arranged to couple to a printed circuit board; and
a heat spreader opposite the surface.

11. The packaged semiconductor component of Claim 10, wherein the side source terminal provides mechanical support for the heat spreader.

12. The packaged semiconductor component of Claim 10 or 11, wherein the heat spreader has a notch around the side source terminal.

13. The packaged semiconductor component of one of claims 9 to 12, wherein each of the first side and the second side of the packaged semiconductor component comprises a lead frame.

14. The packaged semiconductor component of Claim 13, wherein the lead frame comprises a stamped flat end.

15. The packaged semiconductor component of one of claims 9 to 14, further comprising a gate terminal positioned on the third side of the packaged semiconductor component.
